# EUROPEAN PATENT APPLICATION

(11) **EP 1 998 390 A2**
(43) Date of publication of application: **03.12.2008**
(21) Application number: 08156973.3
(22) Date of filing: 27.05.2008
(51) Int. Cl.: H01L 51/52

(54) **Pretreatment method of substrate of organic EL element and manufacturing method for organic EL element**

(30) Priority: 28.05.2007 JP 2007140769
(71) Applicant: Kabushiki Kaisha Toyota Jidoshokki, Kariya-shi, Aichi 448-8671 (JP)
(72) Inventor: Sone, Hirotaka, Kariya-shi Aichi 448-8671 (JP); Omuro, Wataru, Kariya-shi Aichi 448-8671 (JP); Muta, Mitsuharu, Kariya-shi Aichi 448-8671 (JP); Yamamoto, Katsuya, Kariya-shi Aichi 448-8671 (JP)
(74) Representative: TBK-Patent

(57) **Abstract**

The present invention discloses a method for processing a substrate on which transparent electrode made of metal oxide is formed before forming an organic EL element on the transparent electrode. According to the method, the substrate (P) is accommodated in a bake chamber (15) provided with a heater (22). The substrate is heated while mixed gas of oxygen and nitrogen is introduced into the bake chamber (15) so as to replace the gas in the bake chamber. The mixed gas is introduced into the bake chamber in an amount that is 1/60 or more and 1/15 or less of a whole volume of the bake chamber per minute. According to this method, moisture is removed and an appropriate surface treatment is performed for the transparent electrode of metal oxide at the same time.

## Description

### BACKGROUND OF THE INVENTION

The present invention relates to a pretreatment method of a substrate of an organic EL element, more specifically relates to a pretreatment method of a substrate on which a transparent electrode of metal oxide is formed.

Recently, attention has been focused on an organic EL element (organic electroluminescence element) which is a light-emitting element of a self light emitting type. In a basic method for manufacturing an organic EL element, an anode which is a transparent electrode made of an ITO (indium-tin-oxide) is patterned on a substrate, and an organic EL layer and a cathode are laminated on the substrate. The organic EL layer easily receives harmful influence from moisture or oxygen. Therefore, if moisture or impurity collects on the substrate on which anodes are patterned, the manufactured organic EL element may have an area which does not emit light (non light-emitting area) called as a dark spot (or a dark area), or may have unevenness in brightness. Therefore, a pretreatment of the substrate needs to be performed.

The pretreatment of the substrate includes a processing for removing moisture, which causes the dark spot, from the substrate. There has been proposed a pretreatment method of the substrate, in which moisture is removed by heating and moisture is prevented from collecting on the substrate again. For example, Japanese Laid-Open Patent Publication No. 2005-190822 discloses a moisture removing method of a substrate on which an organic EL element is arranged. The organic EL element has a first electrode, an insulating layer, an organic layer at least including a light-emitting layer, and a second electrode, which are laminated in order. This method includes a step of heating the substrate at least after the insulating layer is formed to remove moisture from the substrate and a step of lowering a temperature of the substrate maintaining an atmosphere at a low dew point after the moisture removing processing. The above publication discloses that the temperature of the substrate is lowered while the gas in the atmosphere is discharged and new gas having a low dew point is introduced into the atmosphere or new gas having a low dew point is blown to the substrate.

However, the objective of the pretreatment method of the substrate disclosed in the above publication is limited to removal of moisture on the substrate.

The present inventors have discovered that when the heating process for the substrate is performed by introducing only gaseous nitrogen having a low dew point to a processing chamber as the pretreatment of the substrate on which a transparent electrode of metal oxide is formed, the performance of the organic EL element formed on the substrate may be degraded (for example, unevenness in brightness). Specifically, the present inventors found out that atmosphere gas used for the heating process has adverse influence on the performance of the transparent electrode made of metal oxide. It is also found out that the performance of the manufactured organic EL element may be degraded due to other conditions.

### SUMMARY OF THE INVENTION

It is an objective of the present invention to provide a pretreatment method of a substrate in which moisture on the substrate is removed, and appropriate surface treatment for a transparent electrode made of metal oxide formed on the substrate is performed at the same time of the moisture removing when an organic EL element is manufactured.

To achieve the above object, one aspect of the present invention provides a pretreatment method of a substrate. A transparent electrode made of metal oxide is formed on the substrate and a plurality of layers which forms an organic electroluminescence element are laminated on the transparent electrode after the pretreatment. The pretreatment method includes: accommodating the substrate having the transparent electrode in a processing chamber provided with a heater; heating the substrate while introducing mixed gas of oxygen and inert gas into the processing chamber so as to replace gas in the processing chamber; and setting an introducing velocity of the mixed gas into the processing chamber such that the mixed gas is introduced into the processing chamber in an amount of 1/60 or more and 1/15 or less of the whole volume of the processing chamber per minute.

Another aspect of the present invention provides a manufacturing method for an organic electroluminescence element including: forming a transparent electrode made of metal oxide on a substrate; accommodating the substrate having the transparent electrode in a processing chamber provided with a heater; heating the substrate while introducing mixed gas of oxygen and inert gas to the processing chamber so as to replace gas in the processing chamber; setting an introducing velocity of the mixed gas into the processing chamber such that the mixed gas is introduced into the processing chamber in an amount of 1/60 or more and 1/15 or less of the whole volume of the processing chamber per minute; cooling down the substrate to a room temperature; and laminating a plurality of layers forming the organic electroluminescence element on the transparent electrode.

According to the present invention, not only moisture collecting on the substrate and the transparent electrode is removed, but also reforming of the surface of the transparent electrode made of metal oxide is performed at the same time. "The reforming of the surface of the transparent electrode" refers to a processing in which the performance of the organic EL element which is manufactured by using the substrate for which the surface treatment has been performed satisfies predetermined conditions. The performance of the organic EL element includes, for example, initial characteristics, life, unevenness in brightness, and occurrence of dark spot. Generally, gas used for the heating dry process only functions as carrier gas which transfers moisture evaporated by heating to the outside. The mixed gas according to the present invention functions as carrier gas which transfers the evaporated moisture and also functions to prevent degradation of a surface condition of the transparent electrode made of metal oxide due to the remove of moisture. In other words, oxygen contained in the mixed gas reacts with metal oxide on the surface of the transparent electrode made of metal oxide and reforms the surface condition of the transparent electrode.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1A is a plan view schematically showing an organic EL element manufacturing apparatus according to one embodiment of the present invention;
Fig. 1B is a view schematically showing a bake chamber of the manufacturing apparatus of Fig. 1A; and
Fig. 2 is a view schematically showing a processing chamber according to another embodiment of the present invention.

### DETAILED DESCRIPTION OF THE PREFERRED EMBODIMENTS

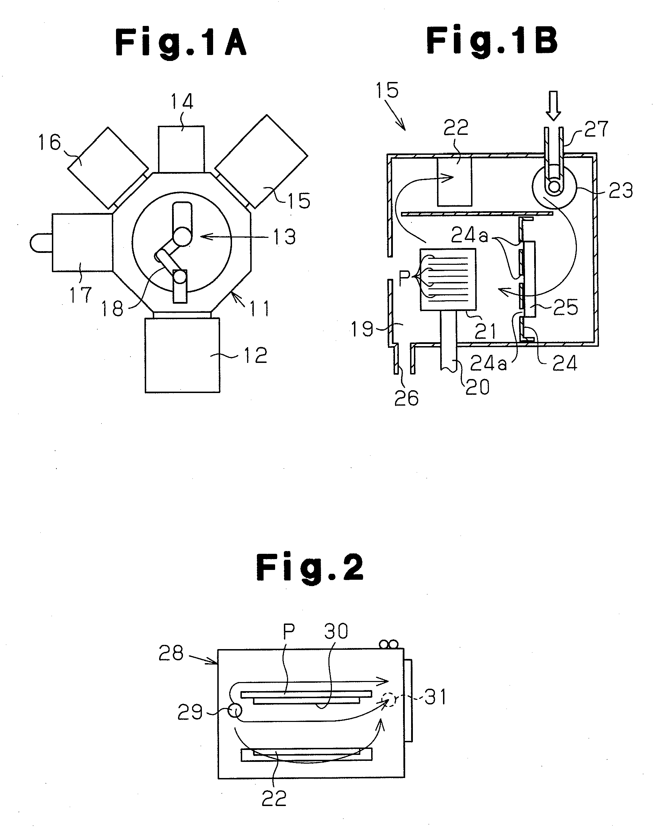

One embodiment of the present invention will be explained with reference to Figs. 1A and 1B. Fig. 1A schematically shows a first block of a plurality of blocks which form an organic EL element manufacturing apparatus.

Various pretreatments are executed in the first block shown in Fig. 1A. The first block has a transport chamber 11 and a plurality of processing chambers 14 to 17 which are connected to each other via the transport chamber 11. The first block has a delivery chamber 12 which is connected to a second block (not shown) where an organic EL layer and an electrode are deposited. The transport chamber 11 has a transport mechanism 13 comprising a robot having a transport arm 18. The transport mechanism 13 transports a substrate to each of the processing chambers 14 to 17 via the transport chamber 11. The transport chamber 11, the delivery chamber 12, and each of the processing chambers 14 to 17 are connected to an evacuation apparatus (not shown) so as to be vacuumed independently by evacuation and to be in atmospheric pressure by the introduction of inert gas after being vacuumed by evacuation.

The processing chamber includes a reversing chamber 14, a bake chamber 15, a UV process chamber 16 and a cooling chamber 17 which are connected to the transport chamber 11 around the transport chamber 11. In the reversing chamber 14, the substrate on which a transparent electrode is patterned is reversed. The substrate is transported from a transfer device (not shown) to the reversing chamber 14. In the bake chamber 15, moisture and other gas contained in the substrate are removed and the transparent electrode is reformed. The bake chamber 15 maintains the inside of the bake chamber 15 in a vacuum state and introduces predetermined gas into the bake chamber 15. Accordingly, baking process (heating process) of the substrate can be performed in predetermined atmosphere. UV process is performed in the UV process chamber 16 so as to remove an organic matter or dust collecting on the surface of the transparent electrode formed on the substrate. Cooling process for the substrate is performed in the cooling chamber 17. After the temperature of the substrate for which the heating process has been performed in the bake chamber 15 is lowered to a predetermined temperature, the substrate is cooled down to have a room temperature in a short time by the cooling process in the cooling chamber 17.

The second block which is connected to the first block has a mask stock chamber and a plurality of deposition chambers (film forming chambers). The substrate for which the pretreatment is performed in the first block is transferred to the second block via the delivery chamber 12. In each of the deposition chambers of the second block, a plurality of layers forming the organic EL element such as an organic EL layer and a cathode layer are formed on the transparent electrode on the substrate.

As shown in Fig. 1B, a cassette accommodation chamber 19 is defined in the bake chamber 15 and a substrate cassette 21 is provided in the cassette accommodation chamber 19. The substrate cassette 21 supports a plurality of substrates P horizontally and is capable of being lifted or lowered by a lift mechanism 20. A sirocco fan 23 is provided in an upper portion of the bake chamber 15. A plurality of slits 24a are formed on a partition wall 24 of the cassette accommodation chamber 19 which is located below the sirocco fan 23. The slits 24a are covered with a HEPA (High Efficiency Particulate Air) filter 25. An air discharging opening 26 is formed in a lower portion of the cassette accommodation chamber 19.

Mixed gas of oxygen and inert gas is introduced from a mixed gas supply portion (not shown) provided outside of the bake chamber 15 to an introduction portion formed at a shaft of the sirocco fan 23 via a pipe 27. The sirocco fan 23 sends the introduced mixed gas to the HEPA filter 25 provided on the partition wall 24. That is, the sirocco fan 23 introduces the mixed gas into the bake chamber 15 at a predetermined introducing velocity. The mixed gas sent to the HEPA filter 25 by the sirocco fan 23 passes through the substrate cassette 21 accommodating a plurality of substrates P and passes through a heater 22 provided in an upper portion of the bake chamber 15 and is sent to the HEPA filter 25 by the sirocco fan 23 again. In other words, the mixed gas sent by the sirocco fan 23 circulates in the bake chamber 15 at a predetermined flow velocity. The flow velocity of the mixed gas circulating in the bake chamber 15 is equal to the introducing velocity of the mixed gas.

The heater 22 is capable of heating the substrate P up to 250°C. The sirocco fan 23 is capable of adjusting the introducing velocity of the mixed gas into the bake chamber 15 such that the flow rate of the introduced mixed gas varies in a range of 0 to 250 L/min.

A manufacturing method of an organic EL element (panel) with the above structured manufacturing apparatus will be explained. A substrate P, on which an ITO (indium-tin-oxide) pattern is formed as a transparent electrode, is prepared using an apparatus different from the manufacturing apparatus shown in Figs. 1A and 1B. The substrate P is transferred to the reversing chamber 14 of the manufacturing apparatus by a transfer device (not shown). A film is deposited on the substrate P with upward deposition in each deposition chamber of the second block. Therefore, the substrate P is reversed in the reversing chamber 14 such that a surface having the transparent electrode faces down. Accordingly, a holding portion of the transport arm 18 can hold a surface having the transparent electrode that is a film forming surface of the substrate P in the transport chamber 11. The substrate P is transported from the UV process chamber 16 to the cooling chamber 17 via the bake chamber 15 and processed in a state that the substrate P is held by a holding portion of the transport arm 18. Accordingly, the pretreatment is performed.

The substrate P for which the pretreatment is performed is transported to the second block via the delivery chamber 12 by the transport arm 18. In the second block, each of the layers forming the organic EL element is laminated on the substrate P.

The baking process, which is one process of the pretreatment, will be explained in details.

The substrate P that is reversed in the reversing chamber 14 is subjected to the UV process in the UV process chamber 16, and then subjected to the baking process in the bake chamber 15. A plurality of substrates P are subjected to the baking process at the same time in a state where the substrates P are accommodated in the substrate cassette 21. In the baking process, the mixed gas of oxygen of which the dew point in atmospheric pressure is -30°C or less and nitrogen of which the dew point in the atmospheric pressure is -30°C or less is introduced to the bake chamber 15 from the outside and part of the mixed gas is discharged to the outside from the air discharging opening 26. In this state, the heater 22 is heated to a predetermined temperature and the baking process is performed in the atmospheric pressure for a predetermined period. The introducing velocity (flow velocity) of the mixed gas is adjusted by the activation of the sirocco fan 23.

The ratio of oxygen and inert gas in the used mixed gas (oxygen: inert gas) is in a range of 1.8:8.2 to 3.0:7.0 in volume, more preferably 2:8 (1:4). For example, nitrogen is used as the inert gas. The introducing velocity of the mixed gas is adjusted such that the mixed gas in the bake chamber 15 is replaced in a range of 1/60 or more and 1/15 or less with respect to the whole volume of the bake chamber 15 per minute. The temperature in the bake chamber 15 is preferably in a range of 170±10°C. The processing time is preferably in a range of 80±10 minutes.

After the substrate is subjected to the heating process under the above conditions, the heating by the heater 22 is stopped. After the temperature of the substrate is lowered to a predetermined temperature (for example, 100°C), the substrate P is transported to the cooling chamber 17 and cooled down to the room temperature. When the substrate P is cooled down, it is preferable that the dried mixed gas having a dew point of -40°C or less in the atmospheric pressure be blown to the substrate P.

With the baking process, the moisture collecting on the substrate P and the transparent electrode formed on the substrate P is removed, and the transparent electrode is activated. Accordingly, organic EL elements having good performance are manufactured.

### EXAMPLES

The pretreatment (baking process) was performed using a test device provided with the bake chamber 15 having a whole volume of 30L. The temperature in the bake chamber 15 was 170°C, and the drying time was 80 minutes, and the mixed gas having a ratio of oxygen and nitrogen being 1:4 in a volume was used. The flow rate of the mixed gas introduced to the bake chamber 15 was varied in a range of 0.2 to 3.3 L/min. The organic EL element manufactured using the substrate P for which the pretreatment was performed was evaluated in the points of initial characteristics, life, unevenness in brightness and occurrence of a dark spot. The results are shown in Table 1.

The initial characteristics are evaluated by applying a predetermined voltage (for example, 4.8V) to the organic EL element. When predetermined brightness was obtained, the initial characteristics were evaluated to be O (passed), and when predetermined brightness was not obtained, the initial characteristics were evaluated to be X (failed).

The life was evaluated by applying direct-current voltage to the organic EL element to activate it with a constant current and measuring a time period in which the brightness was reduced to be half. When it took 500 hours or more to reduce the brightness to be half, the life was evaluated to be O (passed), and when it took less than 500 hours to reduce the brightness to be half, the life was evaluated to be X (failed).

The unevenness in brightness and the occurrence of a dark spot were evaluated by heating the organic EL element at 100°C for five hours. When there was no unevenness in brightness and occurrence of a dark spot, the unevenness in brightness and the occurrence of a dark spot were evaluated to be O (passed), and when at least one of the unevenness in brightness and the occurrence of a dark spot was caused, they were evaluated to be X (failed)

It was evaluated that the organic EL element passed when all the points of initial characteristics, life, unevenness in brightness and occurrence of a dark spot passed.

**[Table 1]**

| Flow rate per a unit volume (L/min) | Initial characteristics | Life | Unevenness in brightness, Occurrence of dark spot | Evaluation |
|---|---|---|---|---|
| 0.2 | X | X | X | X |
| 0.5 | O | O | O | O |
| | O | O | O | O |
| 1.0 | O | O | O | O |
| | O | O | O | O |
| 1.5 | O | O | O | O |
| | O | O | O | O |
| 2.0 | O | O | O | O |
| | O | O | O | O |
| 3.3 | O | X | X | X |

According to Table 1, it was evaluated that the organic EL element failed when the flow rate of the mixed gas was 0.2 L/min and 3.3L/min, and it was evaluated that the organic EL element passed when the flow rate of the mixed gas was in a range of 0.5 L/min to 2.0 L/min. Specifically, the introducing velocity of the mixed gas was adjusted such that the mixed gas was introduced to the bake chamber 15 in an amount of 0.5/30 (= 1/60) or more and 2.0/30 (= 1/15) or less of the whole volume of the bake chamber 15 per minute. The substrate was subjected to the heating process such that the gas in the bake chamber 15 was replaced with the mixed gas that was newly introduced in the bake chamber 15. Accordingly, the organic EL element having good performance was obtained.

The greater the introducing velocity (flow velocity) of the mixed gas, that is, the greater the flow rate of the introduced mixed gas, the better the drying performance becomes. However, in this case, the reforming of the surface of ITO does not easily occur due to oxygen in the mixed gas, and this degrades the performance of the organic EL element. If the introducing velocity (flow velocity) of the mixed gas, that is, the flow rate of the introduced mixed gas, is too small, the substrate is difficult to be dried and the reforming of the surface of ITO due to oxygen hardly occurs.

Using the organic EL element manufacturing apparatus provided with the bake chamber 15 having a whole volume of 2500L, the substrate P was subjected to the baking process under the same conditions as the examples where good results were obtained in the above test device. Specifically, the substrate P was subjected to the baking process while the mixed gas was supplied to the bake chamber 15 at the flow rate of 41.7L/min to 166.7L/min. At the flow rate of 41.7L/min to 166.7L/min, the mixed gas was introduced to the bake chamber 15 in an amount of 1/60 to 1/15 of the whole volume of the bake chamber 15 per minute. The organic EL element manufactured using the substrate P had good performance.

The reforming of the surface of ITO can be performed by plasma processing using the mixed gas of oxygen and argon. However, this increases manufacturing cost since the plasma processing needs to be performed in a separate process from the moisture removing process and a plasma device is required.

The present embodiment has following advantages.
(1) As a pretreatment of the substrate P on which the transparent electrode of ITO is formed, the substrate P is accommodated in the bake chamber 15 provided with the heater 22 and the substrate P is subjected to the heating process while the mixed gas of oxygen and the inert gas is introduced to and discharged from the bake chamber 15 so as to replace the gas in the bake chamber 15. The introducing velocity (flow velocity) of the mixed gas is set such that the mixed gas is introduced to the bake chamber 15 in an amount of 1/60 or more and 1/15 or less of the whole volume of the bake chamber 15 per minute. Therefore, not only the moisture collecting on the substrate P or the transparent electrode can be removed but also the surface of the transparent electrode is reformed. In other words, two appropriate surface treatments can be simultaneously performed for the transparent electrode of ITO.
(2) The ratio of oxygen and inert gas in the used mixed gas (oxygen: inert gas) is in a range of 1.8:8.2 to 3.0:7.0 in a volume. Accordingly, the reforming process is reliably performed for the surface of the transparent electrode made of ITO.
(3) The organic EL element obtained by performing the pretreatment using the mixed gas of oxygen and inert gas has the same performance as the organic EL element that is manufactured using the substrate having the transparent electrode whose surface is subjected to the surface reforming with the plasma processing. Therefore, compared to a case in which the plasma processing is performed using the plasma device, the processes are simple and the manufacturing costs are reduced.
(4) Nitrogen is used as the inert gas. Therefore, costs are reduced compared to a case in which argon or helium is used as the inert gas.
(5) The baking process is performed in the atmospheric pressure. Therefore, a pressure reducing equipment for the baking process is not required.
(6) A plurality of substrates P are subjected to the baking process at the same time in a state that they are accommodated in one substrate cassette 21. Therefore, efficiency of the baking process of the substrates P is improved compared to a case in which the substrates P are subjected to the baking process one by one.

The present embodiment is not limited thereto but may be modified as described below.

As shown in Fig. 2, a processing chamber 28 which integrally forms the bake chamber (heating chamber) and the cooling chamber may be used as the processing chamber for the pretreatment of the substrate P. The heater 22 is provided in a lower portion of the processing chamber 28 and the substrate P is held above the heater 22 in the processing chamber 28. The processing chamber 28 is formed in a rectangular box and has an introduction opening 29 and an air discharging opening 31 such that the mixed gas is introduced from one corner and is discharged from another corner which is on a diagonal from the one corner. When the baking process is performed in the processing chamber 28, the heater 22 is activated to heat the substrate P and the mixed gas is introduced form the introduction opening 29. The introduced mixed gas flows along the substrate P and the transparent electrode 30, and is discharged from the air discharging opening 31. When the substrate P is cooled down, the activation of the heater 22 is stopped and the mixed gas is introduced to the processing chamber 28.

The metal oxide which is a material for the transparent electrode is not limited to an ITO but may be any material known to the art for the transparent electrode, such as an IZO (indium zinc oxide), ZnO (zinc oxide), SnO₂ (stannic oxide) or others.

The substrates P are subjected to the baking process one by one in the processing chamber 28 shown in Fig. 2. When the bake chamber 15 and the cooling chamber 17 are not integrally formed, that is, in the bake chamber 15 shown in Fig. 1B, the substrates P may be subjected to the baking process one by one.

The partition wall 24 in the bake chamber 15 shown in Fig. 1B may be omitted and the sirocco fan 23 may directly blow wind to the substrate cassette 21.

The inert gas is not limited to nitrogen but may be argon or helium or the mixture thereof.

Dried air may be used as the mixed gas of oxygen and inert gas. In this case, cost can be further reduced. The main component of the air is nitrogen, oxygen and argon and the ratio of nitrogen: oxygen: argon is 78.084: 20.946: 0.930. The total of the three components is 99.96% and the air contains quite small amount of other components. Therefore, the dried air is substantially the mixed gas of oxygen and inert gas.

A sheathed or an infrared heater may be used as the heater 22 for heating rapidly.

The heater 22 may be arranged in any position in the bake chamber 15.

When the mixed gas of oxygen and inert gas is introduced into the bake chamber 15 or the processing chamber 28 so as to replace the gas in the chamber 15 or 28, oxygen and inert gas do not necessarily have to be mixed before the gas is introduced into the chambers 15 or 28. For example, an introduction opening of oxygen and an introduction opening of inert gas may be separately formed in the bake chamber 15 or the processing chamber 28 and oxygen and inert gas introduced from the corresponding opening respectively may be mixed in the chamber 15 or 28.

The present invention discloses a method for processing a substrate on which transparent electrode made of metal oxide is formed before forming an organic EL element on the transparent electrode. According to the method, the substrate is accommodated in a bake chamber provided with a heater. The substrate is heated while mixed gas of oxygen and nitrogen is introduced into the bake chamber so as to replace the gas in the bake chamber. The mixed gas is introduced into the bake chamber in an amount that is 1/60 or more and 1/15 or less of a whole volume of the bake chamber per minute. According to this method, moisture is removed and an appropriate surface treatment is performed for the transparent electrode of metal oxide at the same time.

## Claims

1. A pretreatment method of a substrate (P), wherein a transparent electrode (30) made of metal oxide is formed on the substrate (P) and a plurality of layers which forms an organic electroluminescence element are laminated on the transparent electrode (30) after the pretreatment, the pretreatment method being **characterized by**:
accommodating the substrate (P) having the transparent electrode (30) in a processing chamber (15, 28) provided with a heater (22);
heating the substrate (P) while introducing mixed gas of oxygen and inert gas into the processing chamber (15, 28) so as to replace gas in the processing chamber (15, 28); and
setting an introducing velocity of the mixed gas into the processing chamber (15, 28) such that the mixed gas is introduced into the processing chamber (15, 28) in an amount of 1/60 or more and 1/15 or less of the whole volume of the processing chamber (15, 28) per minute.

2. The method according to claim 1, **characterized in that** the ratio of oxygen and inert gas in the mixed gas is in a range of 1.8:8.2 to 3.0:7.0 in a volume.

3. The method according to claim 1 or 2, **characterized in that** the metal oxide is indium-tin-oxide (ITO).

4. The method according to any one of claims 1 to 3, **characterized in that** the heating process is performed in atmospheric pressure at a temperature of 170±10°C for 80±10 minutes.

5. The method according to any one of claims 1 to 4, **characterized in that** the mixed gas is dried air.

6. A manufacturing method for an organic electroluminescence element being **characterized by**:
forming a transparent electrode (30) made of metal oxide on a substrate (P);
accommodating the substrate (P) having the transparent electrode (30) in a processing chamber (15) provided with a heater (22);
heating the substrate (P) while introducing mixed gas of oxygen and inert gas to the processing chamber (15) so as to replace gas in the processing chamber (15);
setting an introducing velocity of the mixed gas into the processing chamber (15) such that the mixed gas is introduced into the processing chamber (15) in an amount of 1/60 or more and 1/15 or less of the whole volume of the processing chamber (15) per minute;
cooling down the substrate (P) to a room temperature; and
laminating a plurality of layers forming the organic electroluminescence element on the transparent electrode (30).
